# EUROPÄISCHE PATENTANMELDUNG

(11) **EP 2 642 542 A1**
(43) Veröffentlichungstag der Anmeldung: **25.09.2013**
(21) Anmeldenummer: 12160694.1
(22) Anmeldetag: 22.03.2012
(51) Int. Cl.: H01L 33/54, H01L 33/58, G02B 3/02

(54) **Leuchtdiode**

(71) Anmelder: Odelo GmbH, 71409 Schwaikheim (DE)
(72) Erfinder: Kunze, Jochen, 47441 Moers (DE); Manth, Thomas, 52076 Aachen (DE)
(74) Vertreter: Benninger, Johannes

(57) **Zusammenfassung**

Es wird eine Leuchtdiode (01) mit:
- mindestens einem LED-Chip (02),
- einer auf dem mindestens einen LED-Chip (02) aufstehenden Längsachse (03), sowie
- einem den LED-Chip (02) wenigstens zum Teil umhüllenden Lichtleitkörper (04), der mindestens zwei konzentrisch zu der Längsachse (03) und zueinander angeordnete Lichtaustrittsflächen (07, 08) aufweist,

beschrieben. Das von dem LED-Chip (02) ausgestrahlte Licht tritt in unterschiedlichen Austrittswinkeln (A1, A2, A3) aus den verschiedenen Lichtaustrittsflächen (07, 08) aus dem Lichtleitkörper (04) aus. Jeder Austrittswinkel (A1, A2, A3) aus den mindestens zwei Lichtaustrittsflächen (07, 08) stellt einen Teilabstrahlwinkel (T1, T2) eines Gesamtabstrahlwinkels der Leuchtdiode (01) dar.

## Beschreibung

Die Erfindung betrifft eine Leuchtdiode gemäß dem Oberbegriff des Anspruchs 1.

Als Lichtquellen kommen unter anderem wegen ihres hohen Wirkungsgrads bei der Umwandlung elektrischen Stroms in Licht und ihres damit einhergehend geringen Stromverbrauchs vermehrt Leuchtdioden zum Einsatz.

Eine Leuchtdiode besteht zumindest aus wenigstens einem Lichtemittierende-Diode-Halbleiter-Chip, kurz LED-Chip, sowie aus mindestens einem Kontaktmittel zur elektrischen Kontaktierung des LED-Chips. Üblicherweise verfügt jede Leuchtdiode über einen Bonddraht je LED-Chip, welcher je einen LED-Chip elektrisch kontaktiert. Dieser Bonddraht bildet ein erstes Kontaktmittel für den LED-Chip der Leuchtdiode. Der Bonddraht kann mit einem ersten elektrischen Anschluss verbunden sein, welcher zur elektrischen Kontaktierung der Leuchtdiode beispielsweise mit einer ersten Leiterbahn eines Leuchtmittelträgers vorgesehen sein kann. Ein zweites Kontaktmittel für den LED-Chip der Leuchtdiode bildet der LED-Chip selbst. Zur elektrischen Kontaktierung kann der LED-Chip mit einem zweiten elektrischen Anschluss verbunden sein, welcher zur elektrischen Kontaktierung der Leuchtdiode beispielsweise mit einer zweiten Leiterbahn eines Leuchtmittelträgers vorgesehen sein kann.

Die Leuchtdiode kann darüber hinaus einen den LED-Chip unmittelbar umgebenden Primärreflektor aufweisen. Dieser Primärreflektor kann beispielsweise durch Wandungen einer den LED-Chip umgebenden Ausnehmung und/oder durch einen Napf gebildet sein, in dem der LED-Chip angeordnet ist. Der Napf kann mit dem erwähnten zweiten Anschluss verbunden sein, diesen bilden oder umfassen oder von diesem umfasst werden.

Bei speziellen Ausführungen von Leuchtdioden können einzelne oder alle Kontaktmittel selbst die elektrischen Anschlüsse bilden, wie nachfolgend zu den verschiedenen Kontaktierungsmöglichkeiten von Leuchtdioden ausgeführt.

Bekannt sind Leuchtdioden zur Durchsteckmontage (THT; Through Hole Technology), oberflächenmontierbare (SMD; Surface Mounted Device) Leuchtdioden und Leuchtdioden, bei denen der LED-Chip in Nacktmontagetechnik (COB; Chip On Board) direkt auf den Leuchtmittelträger gebondet wird.

THT-Leuchtdioden sind der gängig bekannte Typ Leuchtdioden. Sie werden auch als bedrahtete Leuchtdioden bezeichnet, da sie aus einer zumindest in einer gewünschten Abstrahlrichtung transparenten Kapselung, z.B. in Form einer Umspritzung oder eines Vergusses bestehen, welche einen den LED-Chip mit einem ersten elektrischen Anschluss, beispielsweise in Form eines Anodenanschlusses verbindenden Bonddraht und den mit einem zweiten elektrischen Anschluss, beispielsweise in Form eines Kathodenanschlusses, verbundenen LED-Chip einschließt. Aus der Kapselung ragen nur die auch als Beinchen bezeichneten Drähte des ersten elektrischen Anschlusses und des zweiten elektrischen Anschlusses als die Anoden- und Kathodenanschlüsse der THT-Leuchtdiode. Der beispielsweise als Kathodenanschluss ausgeführte zweite elektrische Anschluss kann hierbei mit einem oben erwähnten Napf versehen sein, in dem der LED-Chip angeordnet ist. Der Bonddraht führt vom beispielsweise als Anodenanschluss ausgeführten ersten Anschluss von außerhalb des Napfs kommend zum LED-Chip.

SMD-Leuchtdioden bestehen aus einem Leadframe mit wenigstens einer Bestückungsfläche für mindestens einen LED-Chip sowie elektrischen Anschlussflächen. Das Leadframe ist von einem Kunststoffkörper mit zumindest einer die wenigstens eine Bestückungsfläche freihaltenden Ausnehmung teilweise umspritzt. Die elektrischen Anschlussflächen des Leadframes sind hierbei als die elektrischen Anschlüsse der SMD-Leuchtdiode zur späteren Oberflächenmontage ebenfalls freigehalten. Der mindestens eine LED-Chip ist am Grund der zumindest einen zur wenigstens einen Bestückungsfläche reichenden Ausnehmung angeordnet und elektrisch kontaktiert. Dabei ist der LED-Chip auf einer mit wenigstens einer ersten elektrischen Anschlussfläche verbundenen ersten Partie des Leadframes angeordnet. Ein Bonddraht verbindet den LED-Chip mit einer zweiten Partie des Leadframes, die wiederum mit wenigstens einer zweiten elektrischen Anschlussfläche verbunden ist. Die an ihrem Grund zur Bestückungsfläche reichende Ausnehmung kann reflektorartig ausgestaltet sein. Dabei bilden die Wandungen der Ausnehmung den oben erwähnten Primärreflektor. Hierbei können die Wandungen reflektierend beschichtet sein.

COB-Leuchtdioden bestehen aus einem direkt auf einem Leuchtmittelträger anzuordnenden, ungehäusten LED-Chip und einem Bonddraht. Die Rückseite des LED-Chips bildet dabei den ersten elektrischen Anschluss der COB-Leuchtdiode. Zur elektrischen Kontaktierung wird der LED-Chip auf seiner Rückseite direkt mit einer ersten Leiterbahn eines Leuchtmittelträgers z.B. durch Löten oder Schweißen elektrisch verbunden. Der den zweiten elektrischen Anschluss der COB-Leuchtdiode bildende Bonddraht wird mit einer zweiten Leiterbahn des Leuchtmittelträgers ebenfalls z.B. durch Löten oder Schweißen elektrisch verbunden.

Der Vollständigkeit halber sei ergänzend erwähnt, dass auch andere Kontaktierungen wie z.B. der so genannte Flip-Chip-Aufbau möglich sind, bei dem die Kontaktmittel des LED-Chips direkt mit einem kontaktierten Substrat verbunden sind. In diesen Fällen wird kein Bonddraht verwendet.

Zumindest bei den THT- und SMD-Leuchtdioden ist bekannt, den LED-Chip mittels einer Kapselung umfassend einen diesen wenigstens zum Teil umhüllenden, transparenten, beispielsweise angespritzten Lichtleitkörper einzuschließen.

Herausragende Eigenschaften von Leuchtdioden im Vergleich zu anderen, herkömmlichen Lichtquellen sind neben deren wesentlich längerer Lebensdauer und deren wesentlich höherer Lichtausbeute bei gleicher Leistungsaufnahme deren deutlich kompakteren Abmessungen.

Dies ermöglicht es, in Verbindung mit Leuchtdioden als Lichtquellen Leuchtmittel herzustellen, die an jede erdenkliche Einbausituation angepasst sein können. Dabei können eine oder mehrere, einzeln oder gruppenweise, beispielsweise in einem Strang zu mehreren angeordnete Leuchtdioden als mindestens eine Lichtquelle eines Leuchtmittels vorgesehen sein.

Eine typische Anpassung an die Einbausituation betrifft die Abmessungen und die Form sowie beispielsweise äußere Gestalt einer Leuchte oder einer Leuchtenkammer, für welche ein Leuchtmittel vorgesehen ist.

Eine weitere typische Anpassung an die Einbausituation betrifft den zur Verfügung stehenden Bauraum. Dabei wird ein möglichst geringer Bauraumbedarf angestrebt, um durch Verwendung eines Leuchtmittels mit geringem Bauraumbedarf auch für eine mit einem solchen Leuchtmittel versehene Leuchte insgesamt kompaktere Abmessungen erhalten zu können, wodurch weiter reichende Vorteile erzielt werden können. Beispielsweise steht bei einer als Heckleuchte ausgeführten Kraftfahrzeugleuchte mit geringem Bauraumbedarf mehr Platz für den Kofferraum eines Kraftfahrzeugs zur Verfügung. Gleichzeitig können Material und Gewicht gespart werden, wodurch beispielsweise Energieeinsparungen, wie etwa Verbrauchseinsparungen von Treibstoff oder eine geringere Belastung eines Stromspeichers einhergehend mit einer Verringerung der Umweltbelastung sowohl bei der Herstellung, als auch im Betrieb eines Kraftfahrzeugs erreicht werden können.

Neben der Anpassung an die Einbausituation müssen Leuchtmittel sehr hohe Qualitätsanforderungen erfüllen. So werden beispielsweise bereits geringe Abweichungen von einem homogenen Eindruck des Erscheinungsbilds sowohl im ausgeschalteten Zustand des Leuchtmittels, dem so genannten Kaltzustand, als auch im so genannten Warmzustand bei eingeschaltetem Leuchtmittel, als qualitätsmindernd angesehen.

Ein Beispiel für eine Abweichung von einem homogenen Eindruck des Erscheinungsbilds eines Leuchtmittels ist ein möglicherweise blendender, direkter Blick des Betrachters auf die Lichtquelle eines Leuchtmittels im Warmzustand.

Ein als Lichtleiter bezeichnetes totalreflektierendes (TIR; Total Internal Reflection), lichtleitendes Element mit einem Lichteinkoppelbereich und einem Lichtauskoppelbereich ermöglicht beispielsweise ein vollständiges Verbergen der einen oder mehreren Lichtquellen, indem es das von einer verborgen angeordneten Lichtquelle in es am Lichteinkoppelbereich durch Einstrahlung eingekoppelte Licht in Richtung Auskoppelbereich leitet und dort wieder auskoppelt. Dadurch kann ein direkter Blick auf die Lichtquelle verhindert werden.

Ein Lichtleiter, in den Licht mindestens einer Lichtquelle an mindestens einer Lichteinkoppelfläche wenigstens eines Lichteinkoppelbereichs ein- und an mindestens einer von der Lichteinkoppelfläche verschiedenen Lichtauskoppelfläche zumindest eines Lichtauskoppelbereichs wieder ausgekoppelt wird, kann dabei Teil eines Leuchtmittels sein.

Der Lichtleiter kann beispielsweise stabförmig als so genannter Stablichtleiter und/oder flächig als so genannter Flächenlichtleiter ausgebildet sein, mit einer auf seiner beispielsweise normal zur Hauptabstrahlrichtung einer Kraftfahrzeugleuchte orientierten Vorderseite angeordneten Lichtauskoppelfläche.

Beispiele für Abweichungen von einem homogenen Eindruck des Erscheinungsbilds eines Lichtleiters, wie etwa der eines einen Lichtleiter umfassenden Leuchtmittels, sind allem voran eine Ausleuchtung von gar nicht zur Lichtauskopplung vorgesehener Bereiche, aber auch eine ungleichmäßige Ausleuchtung in einem zur Lichtauskopplung vorgesehenen Lichtauskoppelbereich, beispielsweise einer Lichtauskoppelfläche eines Lichtleiters, im Warmzustand.

Bisher wurde das Problem dadurch umgangen, dass eine breitwinklig abstrahlende Leuchtdiode für Lichtleiteranwendungen verwendet wird. Dabei wird jedoch der Winkel der Totalreflexion von den von der Leuchtdiode abgegebenen Lichtstrahlen unterschritten, so dass die Lichtstrahlen im Lichteinkoppelbereich direkt aus dem Lichtleiter ausgekoppelt werden und nicht innerhalb des Lichtleiters weitergeleitet und verteilt werden. Der Lichteinkoppelbereich ist hierbei deshalb mit einer Blende abgedeckt. Diese Blende verhindert, dass der überstrahlte Lichteinkoppelbereich des Lichtleiters beispielsweise von außerhalb einer Leuchte her sichtbar ist. Dies ist allerdings nur unter bestimmten Voraussetzungen der Gestaltung einer mit einem solchen Lichtleiter versehenen Leuchte, insbesondere Kraftfahrzeugleuchte, möglich.

Dennoch ist das im Lichteinkoppelbereich direkt aus dem Lichtleiter ausgekoppelte Licht für die Nutzung innerhalb des Lichtleiters verloren. Die optische Güte, welche vereinfacht das Verhältnis des von einem Leuchtmittel oder einer Leuchte zu einem bestimmten Zweck abgegebenen und damit lichttechnisch genutzten Lichts zum von der mindestens einen hierfür vorgesehenen Lichtquelle abgestrahlten Licht widerspiegelt, ist damit stark eingeschränkt.

Unabhängig von diesen Maßnahmen kann dadurch aber das nach wie vor bestehende Problem der Verwendung breitwinklig abstrahlender Leuchtdioden zur Lichteinkopplung in einen Lichtleiter nicht behoben werden, wonach am Anfangsbereich des Lichtleiters eine höhere eingekoppelte Lichtleistung vorhanden ist, als am Ende. Dadurch erscheint der Anfangsbereich nahe der Lichteinkopplung heller als das hiervon entfernte Ende oder bei einer beidseitigen Einkopplung ein mittlerer Bereich.

Darüber hinaus sind engwinklig abstrahlende Leuchtdioden bekannt, welche direkt stark gebündelt in den Lichtleiter einkoppeln. Problematisch ist hierbei, ein homogenes Erscheinungsbild des vom Lichtleiter abgestrahlten Lichts zu erhalten. Ein Großteil der Lichtleistung wird erst am dem Lichteinkoppelbereich gegenüber liegenden, hinteren Ende des Lichtleiters erfasst, ausgekoppelt und von diesem abgestrahlt. Bei so genannten gebogenen Lichtleitern mit einem gekrümmten Verlauf führt diese Art des Aufbaus zu für mit bloßem Auge erkennbaren unterschiedlich hellen Bereichen innerhalb des Lichtleiters.

Dies ist dadurch beding, dass punktförmige, eng abstrahlende Lichtquellen, wie diese beispielsweise Leuchtdioden darstellen, innerhalb eines Lichtleiters eine bestimmte Wegstrecke zur für ein homogenes Erscheinungsbild notwendigen Lichtausbreitung benötigen.

Wegen der oft engen Bauraumsituation ist die Wegstrecke oftmals nicht gegeben, die zur einer optimalen Lichtausbreitung notwendig wäre.

Durch DE 103 40 039 B4 ist eine engwinklig abstrahlende Leuchtdiode mit einem LED-Chip und einer Kapselung mit einem den LED-Chip wenigstens zum Teil umhüllenden, angespritzten Lichtleitkörper bekannt. Eine mittig senkrecht auf der Oberfläche des LED-Chips aufstehende Längsachse bildet die optische Achse der Leuchtdiode und definiert deren Lichtabstrahlrichtung. Der Lichtleitkörper weist eine geschlossene Mantelfläche sowie diese von der Oberfläche des LED-Chips in Lichtabstrahlrichtung entlang der Längsachse entfernt abschließend zwei konzentrische Lichtaustrittsflächen auf, eine erste, innere Lichtaustrittsfläche und eine diese umgebende, zweite äußere Lichtaustrittsfläche. Von dem LED-Chip abgestrahltes Licht trifft entweder direkt auf die innere Lichtaustrittsfläche und tritt gegebenenfalls unter Brechung zur Längsachse hin aus dem Lichtleitkörper aus, oder wird unter Totalreflexion zunächst an der Mantelfläche im Lichtleitkörper umgelenkt und tritt dann durch die äußere Lichtaustrittsfläche gegebenenfalls unter Brechung zur Längsachse hin aus dem Lichtleitkörper aus. In einem Querschnitt parallel zur Längsachse weisen die innere, als auch die äußere Lichtabstrahlfläche entweder jeweils eine zur Achse der Lichtabstrahlrichtung symmetrische geometrische Formgebung, oder eine asymmetrische Formgebung auf, so dass sowohl die innere und die äußere Lichtabstrahlfläche den selben Abstrahlwinkelbereich überstreichende Austrittswinkel des vom LED-Chip abgestrahlten und aus dem Lichtleitkörper austretenden Lichts aufweisen. Der Abstrahlwinkelbereich ist dabei sehr eng parallel der Längsachse ausgeprägt.

Nachteilig an dieser Leuchtdiode ist eine sehr hohe Konzentration des Lichts in Richtung parallel zur Längsachse. Hierdurch streut das Licht im Inneren eines Lichtleiters sehr gering und eine homogene Auskopplung aus dem Lichtleiter an dafür üblichen Auskoppelstellen ist nur schwer zu verwirklichen. Mit einer etwas breiteren radialen Lichtabstrahlcharakteristik kann diesem Effekt entgegengewirkt werden, beispielsweise mit einem Abstrahlwinkel von 20-40°, jedoch wird das Licht nicht nur horizontal entlang der Lichtleiters gestreut sondern auch in üblicherweise der vertikalen Richtung, in der nicht ausgekoppelt wird. Die Totalreflexionen der Lichtbündel, die vertikal entlanglaufen werden also über die Länge des Lichtleiters absorbiert oder in eine ungewünschte Richtung ausgekoppelt.

Durch DE 10 2004 042 125 B4 ist eine Leuchtdiode mit einem LED-Chip und einer Kapselung bestehend aus einem den LED-Chip wenigstens zum Teil umhüllenden, angespritzten Lichtleitkörper bekannt. Mittig senkrecht auf der Oberfläche des LED-Chips steht eine die optische Achse bildende Längsachse der Leuchtdiode auf. Eine Lichtabstrahlrichtung der Leuchtdiode ist entlang der Längsachse weg von der Oberfläche des LED-Chips definiert. Der Lichtleitkörper weist eine geschlossene Mantelfläche sowie diese von der Oberfläche des LED-Chips entlang der Längsachse in Lichtabstrahlrichtung entfernt abschließend zwei konzentrische Lichtaustrittsflächen auf, eine erste, innere Lichtaustrittsfläche und eine diese umgebende, zweite äußere Lichtaustrittsfläche. Von dem LED-Chip abgestrahltes Licht trifft entweder direkt auf die innere Lichtaustrittsfläche und tritt gegebenenfalls unter Brechung aus dem Lichtleitkörper aus, oder wird unter Totalreflexion zunächst an der Mantelfläche im Lichtleitkörper umgelenkt und tritt dann durch die äußere Lichtaustrittsfläche gegebenenfalls unter Brechung aus dem Lichtleitkörper aus. Die äußere Lichtaustrittsfläche ist mit einer Vielzahl von Kissenoptiken versehen, welche der Erzeugung einer definierten Lichtabstrahlcharakteristik dienen, wodurch nur ein Teil des aus der äußeren, zweiten Lichtabstrahlfläche austretenden Lichts parallel zur Längsachse abgestrahlt wird. Der verbleibende Teil wird in mehrere Raumrichtungen gestreut. In einem Querschnitt parallel zur Längsachse weisen die innere, als auch die äußere Lichtabstrahlfläche jeweils eine zur Längsachse symmetrische geometrische Formgebung auf. Sowohl die innere, als auch die äußere Lichtabstrahlfläche weisen den selben Grundabstrahlwinkel überstreichende Austrittswinkel des vom LED-Chip abgestrahlten und aus dem Lichtleitkörper austretenden Lichts auf. Die Kissenoptiken der äußeren Lichtaustrittsfläche tragen einer Verbreiterung des Abstrahlwinkelbereichs bei, ohne jedoch vom Grundabstrahlwinkel abzuweichen. Dadurch wird lediglich eine breitere Streuung des aus der mit Kissenoptiken versehenen Lichtaustrittsfläche austretenden Lichts um den Grundabstrahlwinkel herum erreicht.

Nachteilig an dieser Leuchtdiode ist, dass die Zykluszeit in der Produktion relativ lange ist, da ein großer optischer Körper hergestellt werden muss. Dies gilt sowohl für aufgesteckte Optiken als auch für eine mittels Spritzgussverfahren in einem Schuss hergestellte Leuchtdiode. Auch die formgebenden Teile für die Kissenoptiken sind aufgrund der geringen optischen Toleranzen teuer in der Herstellung.

Eine Aufgabe der Erfindung ist die Entwicklung einer Leuchtdiode, welche unter Einhaltung einer hohen optischen Güte als Lichtquelle zur Einstrahlung in einen Lichtleiter geeignet ist und dabei einen homogenen Eindruck des Erscheinungsbilds mindestens eines Lichtauskoppelbereichs mit wenigstens einer Lichtauskoppelfläche des Lichtleiters sicherstellt, sowie darüber hinaus einfach und kostengünstig herstellbar ist.

Die Aufgabe wird gelöst mit den Merkmalen des unabhängigen Anspruchs.

Die Erfindung sieht demnach zur Lösung der Aufgabe unter gleichzeitiger Behebung der erwähnten Nachteile des Standes der Technik eine Leuchtdiode vor.

Die Leuchtdiode kann zur Verwendung in einem Leuchtmittel, beispielsweise einem Leuchtmittel für eine Kraftfahrzeugleuchte geeignet sein.

Die Leuchtdiode kann zur Einstrahlung des von ihr im eingeschalteten Zustand ausgestrahlten Lichts in einen Lichtleiter vorgesehen sein. Der Lichtleiter kann Bestandteil eines Leuchtmittels sein, welches mindestens eine Leuchtdiode als Lichtquelle umfasst. Beispielsweise kann die Leuchtdiode Bestandteil eines Leuchtmittels umfassend mindestens die Leuchtdiode als wenigstens eine Lichtquelle und zumindest einen Lichtleiter sein.

Die Leuchtdiode umfasst mindestens einen LED-Chip. Darüber hinaus umfasst die Leuchtdiode einen den mindestens einen LED-Chip wenigstens zum Teil umhüllenden Lichtleitkörper. Der Lichtleitkörper kann vorzugsweise angespritzt sein. Der Lichtleitkörper kann eine den LED-Chip nebst Kontaktmitteln, beispielsweise einen Bonddraht schützende Kapselung bilden, eine solche Kapselung umfassen oder Teil einer solchen Kapselung sein.

Eine Längsachse der Leuchtdiode steht auf der Oberfläche des LED-Chips auf.

Die Längsachse kann senkrecht, beispielsweise mittig auf der Oberfläche des LED-Chips aufstehen.

Der Lichtleitkörper weist mindestens zwei konzentrisch zur Längsachse und zueinander angeordnete Lichtaustrittsflächen auf. Durch wenigstens eine erste, beispielsweise innere Lichtaustrittsfläche tritt das von dem LED-Chip ausgestrahlte Licht weg von der Oberfläche des LED-Chips in einem ersten Austrittswinkel, beispielsweise in Richtung parallel zur Längsachse, und durch zumindest eine zweite, beispielsweise äußere Lichtaustrittsfläche in einem von dem ersten Austrittswinkel verschiedenen zweiten Austrittswinkel, beispielsweise unter Einschluss eines Winkels gegenüber der Längsachse, aus dem Lichtleitkörper aus.

Jeder Austrittswinkel aus den mindestens zwei Lichtaustrittsflächen stellt einen Teilabstrahlwinkel eines Gesamtabstrahlwinkels der Leuchtdiode dar.

Der Gesamtabstrahlwinkel kann einen einzigen, zusammenhängenden Winkelbereich umfassen oder zwei oder mehrere, nicht zusammenhängende Winkelbereiche.

Der Austrittswinkel jeder Lichtaustrittsfläche kann einen Austrittswinkelbereich umfassen. Jeder Austrittswinkelbereich kann einem Kegel oder Hohlkegel entsprechen, welcher zwischen einem durch einen den Austrittswinkelbereich nach oben hin begrenzenden ersten Raumwinkel gebildeten Kegelmantel und einem durch einen den Austrittswinkelbereich nach unten hin begrenzenden zweiten Raumwinkel gebildeten Kegelmantel eingeschlossen ist. Ist der Austrittswinkelbereich einer Lichtaustrittsfläche nach unten hin durch die Längsachse begrenzt, entsprechend einem Raumwinkel von 0°, handelt es sich bei dem Austrittswinkelbereich um einen Kegel. Bei jedem hiervon verschiedenen den Austrittswinkelbereich nach unten hin begrenzenden Raumwinkel handelt es sich bei dem Austrittswinkelbereich um einen Hohlkegel, entsprechend einer zwischen dem ersten und dem zweiten Raumwinkel um die Längsachse herum austretenden Schar von Lichtstrahlen.

Auch ist eine Ausgestaltung denkbar, bei der zumindest eine Lichtaustrittsfläche einen in seiner radialen Winkellage um die Längsachse herum festgelegten Austrittswinkel oder Austrittswinkelbereich aufweist, entsprechend einem in dieser radialen Winkellage schiefen Kegel oder Hohlkegel.

Auch ist eine hierdurch oder durch andere Maßnahmen hergestellte, von einer Radialsymmetrie abweichende Ausgestaltung denkbar.

Beispielsweise liegen diese beiden Teilabstrahlwinkel bei 0° und 20°, jeweils mit einer die beiden Austrittswinkelbereiche nach oben und unten begrenzenden Halbwertsbreite von 5°-7°. Damit handelt es sich um zwei nicht zusammenhängende Winkelbereiche.

Dabei kann entweder das durch die erste Lichtaustrittsfläche austretende Licht beim Austritt aus dem Lichtleitkörper zur Längsachse hin oder von der Längsachse weg gebrochen werden oder unter einem Winkel zur Längsachse frei von Brechung austreten, wohingegen das durch die zweite Lichtaustrittsfläche austretende Licht beim Austritt aus dem Lichtleitkörper beispielsweise parallel zur Längsachse gebrochen wird oder beispielsweise parallel zur Längsachse frei von Brechung austritt.

Alternativ kann das durch die zweite Lichtaustrittsfläche austretende Licht beim Austritt aus dem Lichtleitkörper zur Längsachse hin oder von der Längsachse weg gebrochen werden oder unter Einschluss eines Winkels zur Längsachse frei von Brechung austreten, wohingegen das durch die erste Lichtaustrittsfläche austretende Licht beim Austritt aus dem Lichtleitkörper beispielsweise parallel zur Längsachse gebrochen wird oder beispielsweise parallel zur Längsachse frei von Brechung austritt.

Der Lichtleitkörper kann eine geschlossene Mantelfläche aufweisen. Die mindestens zwei konzentrisch zueinander und zur Längsachse angeordneten Lichtaustrittsflächen des Lichtleitkörpers schließen die Mantelfläche von der Oberfläche des LED-Chips entlang der Längsachse entfernt ab.

Von dem LED-Chip abgestrahltes und im Lichtleitkörper propagiertes Licht kann entweder direkt auf die mindestens eine erste, vorzugsweise innere Lichtaustrittsfläche treffen, durch welche es dann aus dem Lichtleitkörper austritt, oder kann unter Totalreflexion zunächst an der Mantelfläche im Lichtleitkörper umgelenkt werden, bevor es dann auf die wenigstens eine zweite, bevorzugt äußere Lichtaustrittsfläche trifft, durch welche es dann aus dem Lichtleitkörper austritt.

Der Austritt aus dem Lichtleitkörper durch zumindest die eine erste, beispielsweise innere Lichtaustrittsfläche und/oder durch wenigstens die eine zweite, beispielsweise äußere Lichtaustrittsfläche hindurch erfolgt gegebenenfalls unter Brechung beim Übergang vom Material des Lichtleitkörpers zum diesen umgebenden Medium, typischerweise Luft, parallel und/oder unter einem Winkel zur Längsachse.

In einem die Längsachse einschließenden Querschnitt können die Lichtaustrittsflächen, beispielsweise sowohl die erste, vorzugsweise innere, als auch alternativ oder zusätzlich die zweite, bevorzugt äußere Lichtabstrahlfläche, jeweils eine zur Längsachse symmetrische geometrische Formgebung aufweisen. Alternativ können die Lichtaustrittsflächen, beispielsweise die erste und/oder die zweite Lichtabstrahlfläche, in einem die Längsachse einschließenden Querschnitt betrachtet jeweils in Bezug auf die Längsachse jeweils eine asymmetrische geometrische Formgebung aufweisen.

Jeder die Längsachse einschließende Querschnitt ist durch eine Ebene gebildet, in welcher die Kontur der Lichtaustrittsflächen, beispielsweise der ersten, inneren Lichtaustrittsfläche und der zweiten, äußeren Lichtaustrittsfläche, in dem Querschnitt jeweils eine in dieser Ebene verlaufende Kurve darstellt. Die Kurven der Lichtaustrittsflächen, beispielsweise der ersten, inneren Lichtaustrittsfläche und die Kurve der zweiten, äußeren Lichtaustrittsfläche, können dabei stetig ineinander übergehen oder eine Sprungstelle aufweisen. Die Kurven jeder Lichtaustrittsfläche, beispielsweise die Kurve der ersten, inneren Lichtaustrittsfläche und die Kurve der zweiten, äußeren Lichtaustrittsfläche, bilden jeweils eine Formgebung der Lichtaustrittsflächen, beispielsweise der ersten, inneren Lichtaustrittsfläche und der zweiten, äußeren Lichtaustrittsfläche, in dem die Längsachse einschließenden Querschnitt.

Die Symmetrie- oder Asymmetriebetrachtung bezieht sich dabei jeweils auf die die Formgebung einer Lichtaustrittsfläche beschreibende Kurve beidseits der Längsachse. Demnach genügt es zum Erhalt einer Asymmetrie, wenn zumindest eine der Lichtaustrittsflächen in einem die Längsachse einschließenden Querschnitt beidseits der Längsachse unterschiedliche Kurven aufweist. Die verbleibenden Lichtaustrittsflächen können dabei jeweils identische Kurven aufweisen. Grundsätzlich ist aber auch eine Variation aller Kurven aller Lichtaustrittsflächen denkbar.

Die symmetrischen und/oder asymmetrischen geometrischen Formgebungen können dabei in die Längsachse einschließenden Querschnitten in unterschiedlichen Winkellagen um die Längsachse herum jeweils identisch oder beschränkt auf beispielsweise höchstens zwei die Längsachse einschließende Querschnitte in unterschiedlichen Winkellagen jeweils verschieden sein. Die identische und/oder verschiedene Formgebung der Lichtaustrittsflächen in unterschiedlichen die Längsachse einschließenden Querschnitten in unterschiedlichen Winkellagen um die Längsachse herum kann abhängig von den verschiedenen Abstrahlwinkeln des Lichts aus den mindestens zwei Lichtaustrittsflächen ausgeführt sein.

Die Einschränkung auf höchstens zwei die Längsachse einschließende Querschnitte mit gleicher Formgebung der Lichtaustrittsflächen erlaubt die Herstellung eines um die Längsachse herum symmetrischen Lichtleitkörpers mit Paaren von jeweils identischer Formgebungen der Lichtaustrittsflächen in beispielsweise jeweils um 180° um die Längsachse verdrehten Winkellagen. Eine Leuchtdiode mit einem solchen Lichtleitkörper kann beispielsweise zur Einkopplung von Licht in einen gekrümmt verlaufenden Lichtleiter besonders geeignet sein.

Eine vorteilhafte Ausgestaltung der Erfindung sieht vor, dass eine erste, innere Lichtaustrittsfläche in einem die Längsachse einschließenden Querschnitt zumindest abschnittsweise eine geometrische Formgebung entsprechend einer konvexen Wölbung aufweist.

Eine zweite, äußere Lichtaustrittsfläche weist bevorzugt zumindest abschnittsweise eine geometrische Formgebung entsprechend einer Ebene auf.

Die Ebene kann normal oder geneigt zur Längsachse angeordnet sein.

Alternativ kann eine zweite, äußere Lichtaustrittsfläche zumindest abschnittsweise eine geometrische Formgebung entsprechend einem zur ersten, inneren Lichtaustrittsfläche bzw. zur Längsachse hin aufsteigenden Kegelmantel oder einem zur ersten, inneren Lichtaustrittsfläche bzw. zur Längsachse hin abfallenden Trichter aufweisen.

Ebenfalls ist denkbar, dass eine zweite, äußere Lichtaustrittsfläche zumindest abschnittsweise eine geometrische Formgebung entsprechend einer in einem die Längsachse einschließenden Querschnitt betrachtet normal zur Längsachse liegenden Geraden aufweist.

Eine alternative oder zusätzliche vorteilhafte Ausgestaltung der Erfindung sieht vor, dass eine zweite, äußere Lichtaustrittsfläche zumindest abschnittsweise eine geometrische Formgebung mit einer in einem die Längsachse einschließenden Querschnitt betrachtet zu einer benachbarten, näher der Längsachse liegenden Lichtaustrittsfläche hin abfallenden konvexen oder konkaven Wölbung aufweist.

Eine besonders vorteilhafte Ausgestaltung der Erfindung sieht vor, dass eine zweite, äußere Lichtaustrittsfläche alternativ oder zusätzlich zumindest abschnittsweise eine geometrische Formgebung mit einer in einem die Längsachse einschließenden Querschnitt betrachtet von einer benachbarten, näher der Längsachse liegenden Lichtaustrittsfläche weg abfallenden Wölbung aufweisen kann.

In Richtung der Längsachse weg von der Oberfläche des LED-Chips gesehen kann eine zweite, äußere Lichtaustrittsfläche eine erste, innere Lichtaustrittsfläche überragen.

In einem normal zur Längsachse liegenden Querschnitt betrachtet bzw. in einer Draufsicht entlang der Längsachse gesehen können die Lichtaustrittsflächen beliebige Außenkonturen, beispielsweise jeweils eine elliptische Außenkontur aufweisen.

Insbesondere bei langen Lichtleitern nimmt die Lichtleistung am vom Lichteinkoppelbereich entfernten Ende des Lichtleiters oder bei beidseitiger Lichteinkopplung zur Mitte des Lichtleiters hin stark ab. Dies wird durch die vorliegende Erfindung vermieden, da bei der Leuchtdiode beispielsweise das aus einer ersten Lichtaustrittsfläche austretende Licht einen ersten, engwinkligen Teilabstrahlwinkel, beispielsweise parallel zur Längsachse speziell für den dem Einkoppelbereich entfernt liegenden, zur Lichtauskopplung vorgesehenen Bereich des Lichtleiters aufweist. Für einen dem Einkoppelbereich näher liegenden, ebenfalls zur Lichtauskopplung vorgesehenen Bereich des Lichtleiters weist beispielsweise das aus einer zweiten Lichtaustrittsfläche austretende Licht einen beispielsweise etwas breiteren, zweiten Teilabstrahlwinkel zur Längsachse auf bzw. ist ein solcher breiterer, zweiter Teilabstrahlwinkel eingestellt.

Es ist ersichtlich, dass die Erfindung durch eine Leuchtdiode verwirklicht sein kann, die mindestens zwei Abstrahlwinkel besitzt. Die Leuchtdiode weist hierzu mindestens zwei, vorzugsweise konzentrisch angeordnete Lichtabstrahlflächen auf, jeweils eine Lichtabstrahlfläche je Abstrahlwinkel. Jeder Abstrahlwinkel einer Lichtaustrittsfläche bildet einen Teilabstrahlwinkel des Gesamtabstrahlwinkels der Leuchtdiode. Ein Teilwinkel bewirkt hierbei die effiziente Ausleuchtung der Lichtauskoppeloptiken im Anfangsbereich des Lichtleiters, ohne jedoch einen so breiten Abstrahlwinkel zu umfassen, dass die emittierten Lichtstrahlen der Leuchtdiode innerhalb des Lichtleiters den Totalreflexionsbereich verlassen und direkt ausgekoppelt werden. Ein zweiter Teilwinkel bewirkt die effiziente Ausleuchtung der Auskoppeloptiken im vom Lichteinkoppelbereich entfernten, hinteren Bereich des Lichtleiters.

Vorteile gegenüber dem Stand der Technik sind unter Anderem der Verzicht auf kleine und damit schwierig unter hohem Kostenaufwand herzustellender optischer Strukturen auf den Lichtaustrittsflächen sowie ein geringes Volumen des Lichtleitkörpers, wodurch kurze Zykluszeiten bei der Herstellung erreicht werden können. Solche kurzen Zykluszeiten sind Voraussetzung für eine kostengünstige Herstellung, da damit die an einem Produktionsstandort nur in begrenzter Anzahl vorhandenen Produktionseinrichtungen schnell wieder frei gegeben werden, wodurch sie zur Herstellung des nächsten Produkts wieder zur Verfügung stehen.

Weitere Vorteile gegenüber dem Stand der Technik sind, dass durch die unterschiedlichen Abstrahlwinkel sowohl nahe dem Lichteinkoppelbereich eines Lichtleiters liegende, bereits zur Lichtauskopplung vorgesehene Partien eines Lichtauskoppelbereichs des Lichtleiters so ausgeleuchtet werden, dass ein homogener Eindruck der Lichtauskoppelfläche dieser Partien des Lichtleiters erhalten wird. Der gebündelte Anteil propagiert weiter im Lichtleiter und sorgt für eine Ausleuchtung von dem Lichteinkoppelbereich entfernten, ebenfalls zur Lichtauskopplung vorgesehener Partien eines Lichtauskoppelbereichs des Lichtleiters, so dass ebenfalls ein homogener Eindruck der Lichtauskoppelfläche dieser Partien des Lichtleiters erhalten wird. Die spezielle Ausgestaltung der Leuchtdiode stellt sicher, dass kein oder nur sehr wenig Licht einer lichttechnischen Verwendung verloren geht. Hierdurch wird eine sehr hohe optische Güte erhalten.

Zusätzliche sich durch eine Verbesserung der optischen Güte ergebende Vorteile gegenüber dem Stand der Technik sind ein homogenes Erscheinungsbild sowohl eines Lichtleiters, in welchen Licht einer solchen Leuchtdiode eingekoppelt wird aus verschiedenen Betrachtungsrichtungen frei von durch das menschliche Auge wahrnehmbaren, unterschiedlichen Helligkeiten unter gleichzeitiger Erfüllung der beispielsweise durch gesetzliche Vorschriften vorgegebenen und die Lichtverteilung in einer oder mehreren Vorzugsrichtungen sowie die Leuchtdichte in der mindestens einen Vorzugsrichtung umfassenden lichttechnischen Anforderungen bei gleichzeitig geringer erforderlicher in den Lichtleiter einzukoppelnder Strahlungsleistung bzw. geringem erforderlichem in den Lichtleiter einzukoppelndem Lichtstrom. Hierdurch wird ein besonders wirtschaftlicher und effektiver Umgang mit der zur Verfügung stehenden Energie erzielt. Bei Kraftfahrzeuganwendungen ergibt sich dadurch eine besonders günstige Auslegung und Dimensionierung des Bordnetzes einhergehend mit einer verbesserten Wirtschaftlichkeit und Gewichtseinsparungen.

Die Erfindung wird nachfolgend anhand von in den Zeichnungen dargestellter Ausführungsbeispiele näher erläutert. Darin bezeichnen gleiche Bezugszeichen gleiche oder gleich wirkende Elemente. Der Übersicht halber sind nur Bezugszeichen in den einzelnen Zeichnungen dargestellt, die für die Beschreibung der jeweiligen Zeichnung erforderlich sind. Die Größenverhältnisse der einzelnen Elemente zueinander entsprechen dabei nicht immer den realen Größenverhältnissen, da einige Formen vereinfacht und andere Formen zur besseren Veranschaulichung vergrößert im Verhältnis zu anderen Elementen dargestellt sind. Es zeigen in schematischer Darstellung:
- Fig. 1: einen eine Längsachse einschließenden Querschnitt durch eine Leuchtdiode gemäß eines ersten Ausführungsbeispiels mit einem Lichtleitkörper mit zwei konzentrisch zu der Längsachse und zueinander angeordneten, symmetrisch ausgeführten Lichtaustrittsflächen, durch welche das Licht in unterschiedlichen Austrittswinkeln austritt.
- Fig. 2: einen eine Längsachse einschließenden Querschnitt durch eine Leuchtdiode gemäß eines zweiten Ausführungsbeispiels mit einem Lichtleitkörper mit zwei konzentrisch zu der Längsachse und zueinander angeordneten, symmetrisch ausgeführten Lichtaustrittsflächen, durch welche das Licht in unterschiedlichen Austrittswinkeln austritt.
- Fig. 3: eine Lichtabstrahlcharakteristik einer in Fig. 1 oder in Fig. 2 dargestellten Leuchtdiode in einer ersten Darstellungsform.
- Fig. 4: eine Lichtabstrahlcharakteristik einer in Fig. 1 oder in Fig. 2 dargestellten Leuchtdiode in einer zweiten Darstellungsform in Polarkooordinaten.
- Fig. 5: einen eine Längsachse einschließenden Querschnitt durch eine Leuchtdiode gemäß eines dritten Ausführungsbeispiels mit einem Lichtleitkörper mit zwei konzentrisch zu der Längsachse und zueinander angeordneten, asymmetrisch ausgeführten Lichtaustrittsflächen, durch welche das Licht in unterschiedlichen Austrittswinkeln austritt.
- Fig. 6: eine Lichtabstrahlcharakteristik einer in Fig. 5 dargestellten Leuchtdiode.

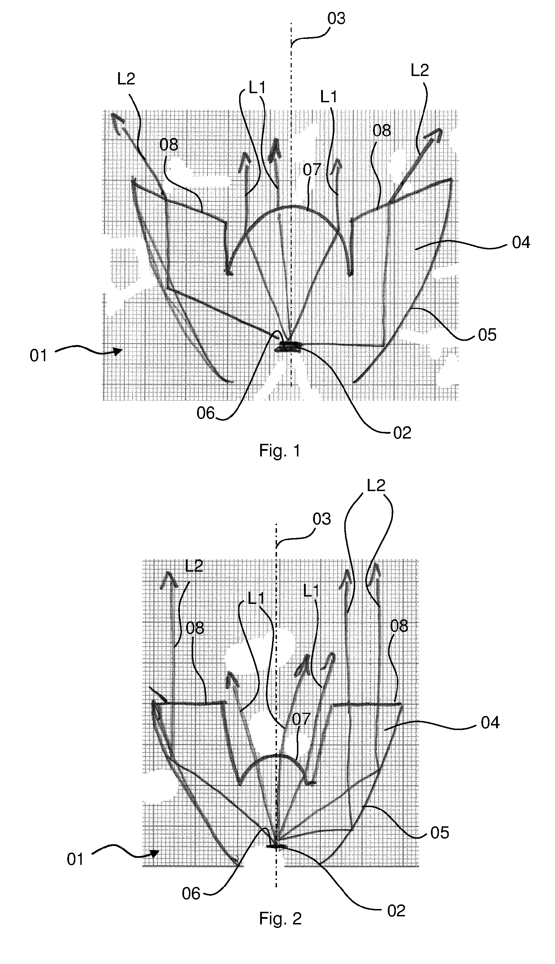

Eine in Fig. 1, Fig. 2 und Fig. 5 ganz oder in Teilen dargestellte, beispielsweise zur Verwendung in einem Leuchtmittel für eine als Heckleuchte ausgeführte Kraftfahrzeugleuchte vorgesehene Leuchtdiode 01 weist wenigstens einen LED-Chip 02 auf. Eine Längsachse 03 steht auf dem mindestens einen LED-Chip 02 auf.

Die Leuchtdiode 01 umfasst außerdem einen den LED-Chip 02 wenigstens zum Teil umhüllenden Lichtleitkörper 04. Der Lichtleitkörper 04 kann eine zumindest den LED-Chip 02 schützende Kapselung bilden, oder eine solche umfassen, oder Teil einer solchen Kapselung sein. Zumindest der Lichtleitkörper 04 einer solchen Kapselung ist aus einem transparenten, klaren oder eingefärbten, beispielsweise spritzgussgeeigneten Werkstoff, besonders bevorzugt einem Kunststoff hergestellt.

Der Lichtleitkörper weist mindestens zwei konzentrische Lichtaustrittsflächen 07, 08 auf.

Die Längsachse 03 kann beispielsweise mittig, vorzugsweise senkrecht auf der Oberfläche 06 des LED-Chips 02 aufstehen.

Das schematisch vermittels durch Pfeile L1, L2 angedeutete Lichtstrahlen dargestellte, von dem LED-Chip 02 ausgestrahlte Licht tritt in unterschiedlichen Austrittswinkeln aus den verschiedenen Lichtaustrittsflächen 07, 08 aus dem Lichtleitkörper 04 aus.

Beispielsweise tritt das durch die vermittels Pfeile L1 angedeuteten Lichtstrahlen dargestellte Licht in einem ersten Austrittswinkel durch eine erste, beispielsweise innere Lichtaustrittsfläche 07 aus, beispielsweise wie in Fig. 1 dargestellt in Richtung parallel zur Längsachse 03. Das durch die vermittels Pfeile L2 angedeuteten Lichtstrahlen dargestellte Licht tritt durch eine zweite, beispielsweise äußere Lichtaustrittsfläche 08 in einem von dem ersten Austrittswinkel verschiedenen zweiten Austrittswinkel aus, beispielsweise wie in Fig. 1 dargestellt unter Einschluss eines Winkels gegenüber der Längsachse 03.

Dabei kann das durch die zweite Lichtaustrittsfläche 08 austretende Licht beim Austritt aus dem Lichtleitkörper 04 zur Längsachse 03 hin oder wie in Fig. 1 dargestellt von der Längsachse 03 weg gebrochen werden oder unter Einschluss eines Winkels zur Längsachse 03 frei von Brechung aus dem Lichtleitkörper 04 austreten, wohingegen das durch die erste Lichtaustrittsfläche 07 austretende Licht beim Austritt aus dem Lichtleitkörper 04 beispielsweise parallel zur Längsachse 03 gebrochen wird oder beispielsweise parallel zur Längsachse 03 frei von Brechung austritt.

Alternativ kann entweder das durch die erste Lichtaustrittsfläche 07 austretende Licht beim Austritt aus dem Lichtleitkörper 04 zur Längsachse 03 hin oder wie in Fig. 2 dargestellt von der Längsachse 03 weg gebrochen werden oder unter einem Winkel zur Längsachse 03 frei von Brechung austreten, wohingegen das durch die zweite Lichtaustrittsfläche 08 austretende Licht beim Austritt aus dem Lichtleitkörper 04 beispielsweise parallel zur Längsachse 03 gebrochen wird oder beispielsweise parallel zur Längsachse 03 frei von Brechung austritt.

Eine gegebenenfalls stattfindende Brechung erfolgt dabei beim Übergang vom Material des Lichtleitkörpers 04 zum diesen umgebenden Medium, typischerweise Luft.

Der Lichtleitkörper 04 kann dabei eine geschlossene Mantelfläche 05 aufweisen. Die mindestens zwei konzentrischen Lichtaustrittsflächen 07, 08, beispielsweise die erste, innere Lichtaustrittsfläche 07 und die zweite, äußere Lichtaustrittsfläche 08, schließen die Mantelfläche 05 von der Oberfläche 06 des LED-Chips 02 entlang der Längsachse 03 entfernt ab. Von dem LED-Chip 02 abgestrahltes, schematisch vermittels durch die Pfeile L1, L2 angedeutete Lichtstrahlen dargestelltes Licht trifft entweder direkt auf die erste, innere Lichtaustrittsfläche 07, durch welche es dann aus dem Lichtleitkörper 04 austritt, oder wird wie in Fig. 1, Fig. 2 und Fig. 5 dargestellt unter Totalreflexion zunächst an der Mantelfläche 05 im Lichtleitkörper 04 umgelenkt, bevor es dann auf die zweite, äußere Lichtaustrittsfläche 08 trifft, durch welche es dann aus dem Lichtleitkörper 04 austritt.

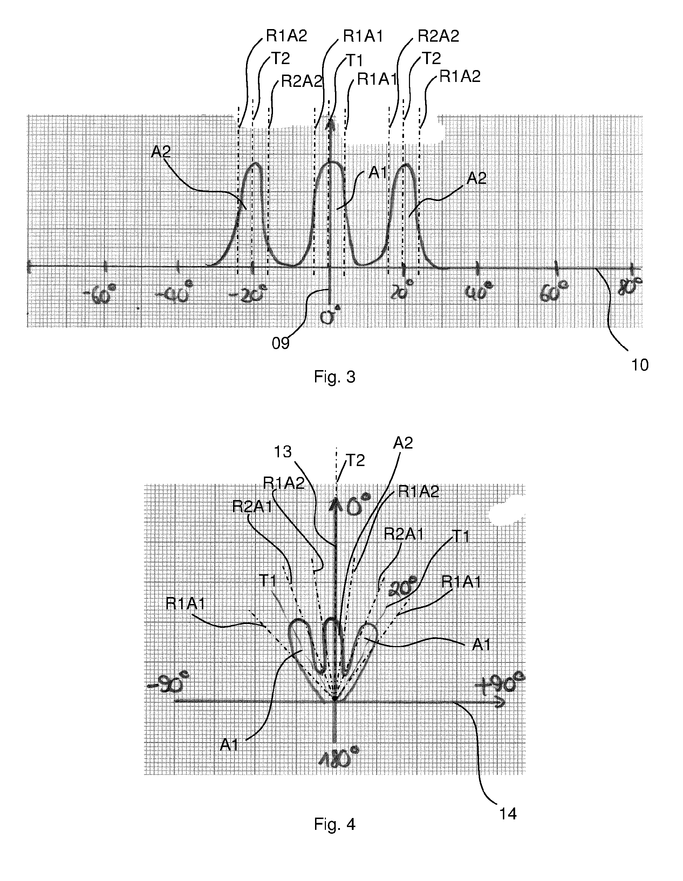

Fig. 3 zeigt eine Darstellung einer auf der Abszissenachse 09 aufgetragenen, abgegebenen Lichtleistung der Leuchtdiode 01 aus Fig. 1 in Abhängigkeit von auf der Ordinatenachse 10 aufgetragenen Austrittswinkeln.

Fig. 4 zeigt eine polare Darstellung entsprechend einer Verteilung der Lichtleistung in einer Seitenansicht für die Leuchtdiode 01 aus Fig. 2. Eine vertikale Achse 13 der polaren Darstellung verläuft dabei in Richtung der Längsachse 03 der Leuchtdiode 01, eine horizontale Achse 14 in einer normal zur Längsachse 03 liegenden, beispielsweise die Oberfläche 06 des LED-Chips 02 einschließenden Ebene.

Der Austrittswinkel jeder Lichtaustrittsfläche 07, 08 umfasst bevorzugt einen in Fig. 3 und Fig. 4 dargestellten Austrittswinkelbereich A1, A2. Ein erster Austrittswinkelbereich A1 ist einer ersten, inneren Lichtaustrittsfläche 07 zugeordnet, ein zweiter Austrittswinkelbereich A2 einer zweiten, äußeren Lichtaustrittsfläche.

Bei der Leuchtdiode 01 in Fig. 1 tritt das Licht im Austrittswinkelbereich A1 entlang der Längsachse 03 aus der ersten, inneren Lichtaustrittsfläche 07 aus, wohingegen das Licht im Austrittswinkelbereich A2 unter einem Winkel zur Längsachse 03 aus der zweiten, äußeren Lichtaustrittsfläche 08 austritt, entsprechend der Darstellung der Austrittswinkelbereiche A1, A2 in Fig. 3.

Bei der Leuchtdiode 01 in Fig. 2 verhält es sich umgekehrt. Dort tritt das Licht im Austrittswinkelbereich A1 unter einem Winkel zur Längsachse 03 aus der ersten, inneren Lichtaustrittsfläche 07 aus, wohingegen das Licht im Austrittswinkelbereich A2 entlang der Längsachse 03 aus der zweiten, äußeren Lichtaustrittsfläche 08 austritt, entsprechend der Darstellung der Austrittswinkelbereiche A1, A2 in Fig. 4.

Jeder Austrittswinkelbereich A1, A2 kann dabei einem Kegel oder Hohlkegel entsprechen, welcher zwischen einem durch einen den Austrittswinkelbereich A1, A2 dem Betrage nach nach oben hin begrenzenden ersten Raumwinkel R1A1, R1A2 gebildeten Kegelmantel und einem durch einen den Austrittswinkelbereich A1, A2 dem Betrage nach nach unten hin begrenzenden zweiten Raumwinkel R2A1, R2A2 gebildeten Kegelmantel eingeschlossen ist. Ist der Austrittswinkelbereich A1, A2 einer Lichtaustrittsfläche 07, 08 nach unten hin durch die Längsachse 03 begrenzt, entsprechend einem Raumwinkel von 0°, handelt es sich bei dem Austrittswinkelbereich A1, A2 um einen Kegel, entsprechend dem Austrittswinkelbereich A1 in Fig. 3 und dem Austrittswinkelbereich A2 in Fig. 4.

Bei jedem von 0° verschiedenen, den Austrittswinkelbereich A1, A2 dem Betrage nach nach unten hin begrenzenden Raumwinkel R2A1, R2A2 handelt es sich bei dem Austrittswinkelbereich A1, A2 um einen Hohlkegel, entsprechend einer zwischen dem ersten Raumwinkel R1A1, R1A2 und dem zweiten Raumwinkel R2A1, R2A2 um die Längsachse 03 herum austretenden Schar von Lichtstrahlen L1, L2.

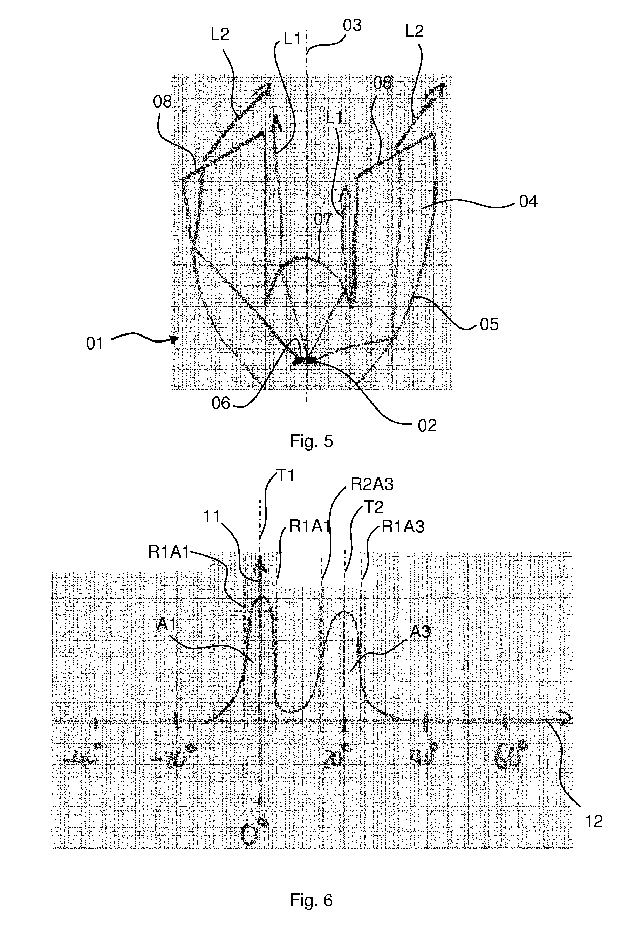

Zumindest eine Lichtaustrittsfläche 07, 08 kann einen in seiner radialen Winkellage um die Längsachse 03 herum festgelegten Austrittswinkel oder Austrittswinkelbereich A3 aufweisen, entsprechend einem in dieser radialen Winkellage schiefen Kegel oder Hohlkegel, wie in Fig. 6 mit einer auf der Abszissenachse 11 aufgetragenen, abgegebenen Lichtleistung in Abhängigkeit von auf der Ordinatenachse 12 aufgetragenen Austrittswinkeln für die in Fig. 5 gezeigte Leuchtdiode 01 dargestellt.

Dabei tritt das vom LED-Chip 02 abgestrahlte und durch Pfeile L1 angedeutete Lichtstrahlen dargestellte Licht unter einem ersten Austrittswinkel oder Austrittswinkelbereich A1 entlang der Längsachse 03 durch eine erste, innere Lichtaustrittsfläche 07 radialsymmetrisch aus dem Lichtleitkörper 04 aus. Das durch Pfeile L2 angedeutete Lichtstrahlen dargestellte Licht hingegen tritt unter einem zweiten Austrittswinkel oder Austrittswinkelbereich A3 in einer vorgegebenen radialen Winkellage um die Längsachse 03 herum unter einem Winkel zur Längsachse 03 durch eine zweite, äußere Lichtaustrittsfläche 08 aus dem Lichtleitkörper 04 aus.

Der Austrittswinkelbereich A3 ist hierbei nicht radialsymmetrisch, wie in Fig. 6. erkennbar.

Auch hierbei können die Austrittswinkelbereiche A1, A3 durch dem Betrage nach erste, obere Raumwinkel R1A1, R1A3 und zweite, untere Raumwinkel R2A1, R2A3 begrenzt sein, wobei im in Fig.6 dargestellten Ausführungsbeispiel R2A1=0° ist, weshalb dieser Raumwinkel nicht dargestellt ist.

Wichtig ist hervorzuheben, dass jeder Austrittswinkel oder Austrittswinkelbereich A1, A2, A3 aus den mindestens zwei Lichtaustrittsflächen 07, 08 einen Teilabstrahlwinkel T1, T2 eines Gesamtabstrahlwinkels der Leuchtdiode 01 bildet oder einen solchen darstellt. Der Gesamtabstrahlwinkel kann einen einzigen, zusammenhängenden Winkelbereich umfassen, oder wie in Fig. 3, Fig. 4, Fig. 6 dargestellt mindestens zwei nicht zusammenhängende Winkelbereiche.

Bei den in Fig. 3, Fig. 4 und Fig. 6 dargestellten, durch die Austrittswinkelbereiche A1, A2, A3 gebildeten Teilabstrahlwinkeln T1, T2 eines Gesamtabstrahlwinkels handelt es sich um einen Teilabstrahlwinkel T1 bei 0° und einen Teilabstrahlwinkel T2 bei 20°, jeweils mit einer die beiden Austrittswinkelbereiche A1, A2, A3 nach oben und unten begrenzenden Halbwertsbreite von 5°-7°.

Bei den in Fig. 1, Fig. 2 und Fig. 5 dargestellten Leuchtdioden 01 wird eine erste, innere Lichtaustrittsfläche 07 von einer diese umgebenden, zweiten Lichtaustrittsfläche 08 entlang der Längsachse 03 in Richtung weg von der Oberfläche 06 des LED-Chips 02 überragt.

In einem in Fig. 1, Fig. 2 und Fig. 5 dargestellten, die Längsachse 03 einschließenden Querschnitt können die Lichtaustrittsflächen 07, 08, beispielsweise sowohl die erste, vorzugsweise innere Lichtaustrittsfläche 07, als auch alternativ oder zusätzlich die zweite, bevorzugt äußere Lichtabstrahlfläche 08, jeweils eine zur Längsachse 03 symmetrische geometrische Formgebung aufweisen (Fig. 1, Fig. 2). Alternativ können die Lichtaustrittsflächen 07, 08, beispielsweise die erste Lichtabstrahlfläche 07 und/oder die zweite Lichtabstrahlfläche 08, in einem die Längsachse 03 einschließenden Querschnitt betrachtet jeweils in Bezug auf die Längsachse 03 jeweils eine asymmetrische geometrische Formgebung aufweisen (Fig. 3).

Die Symmetrie- oder Asymmetriebetrachtung bezieht sich dabei jeweils auf die die Formgebung einer Lichtaustrittsfläche 07, 08 beschreibende Kurve beidseits der Längsachse 03 in dem die Längsachse 03 einschließenden Querschnitt betrachtet. Demnach genügt es zum Erhalt einer Asymmetrie, wenn zumindest eine der Lichtaustrittsflächen 07, 08 in einem die Längsachse 03 einschließenden Querschnitt beidseits der Längsachse 03 unterschiedliche Kurven aufweist. Die verbleibenden Lichtaustrittsflächen 08, 07 können dabei jeweils identische Kurven aufweisen. Grundsätzlich ist aber auch eine Variation aller Kurven aller Lichtaustrittsflächen 07, 08 denkbar.

Durch die zuvor beschriebenen Maßnahmen wird eine Leuchtdiode 01 geschaffen, welche eine für einen Anwendungsfall gezielt hergestellte Lichtabstrahlcharakteristik mit mehreren, durch unterschiedliche Austrittswinkel bzw. Austrittswinkelbereiche A1, A2, A3 verschiedener Lichtaustrittsflächen hergestellte Teilabstrahlwinkel eines Gesamtabstrahlwinkelbereichs der Leuchtdiode 01 für unterschiedliche, homogen auszuleuchtende Partien eines oder mehrerer Lichtaustrittsbereiche eines Lichtleiters aufweist. Eine solche Leuchtdiode 01 ist zur Behebung der Eingangs erwähnten Nachteile des Standes der Technik ideal, da diese so hergestellt werden kann, dass sie in gewünschten Austrittswinkeln bzw. Austrittswinkelbereichen A1, A2, A3 gezielt vorgegebene Lichtleistungen emittiert.

Weitere Vorteile ergeben sich durch den Verzicht auf aufwändige Kissenoptiken und große optische Körper, welche aufgrund der geringen optischen Toleranzen entweder sehr aufwändig und damit teuer in der Entwicklung, Werkzeugherstellung sind, oder da ein großer optischer Körper hergestellt werden muss aufgrund einer langen Zykluszeit in der Produktion teuer sind.

Die Erfindung ist insbesondere im Bereich der Herstellung von Leuchtdioden als Lichtquellen für Beleuchtungszwecke sowie für Kraftfahrzeugleuchten gewerblich anwendbar.

### Bezugszeichenliste

- 01: Leuchtdiode
- 02: LED-Chip
- 03: optische Achse
- 04: Lichtleitkörper
- 05: Mantelfläche
- 06: Oberfläche des LED-Chips
- 07: erste Lichtaustrittsfläche
- 08: zweite Lichtaustrittsfläche
- 09: Abszissenachse
- 10: Ordinatenachse
- 11: Abszissenachse
- 12: Ordinatenachse
- 13: vertikale Achse
- 14: horizontale Achse
- L1: durch die erste Lichtaustrittsfläche austretende Lichtstrahlen
- L1: durch die zweite Lichtaustrittsfläche austretende Lichtstrahlen
- A1: Austrittswinkelbereich der Lichtstrahlen L1
- A2: Austrittswinkelbereich der Lichtstrahlen L2
- A3: Austrittswinkelbereich der Lichtstrahlen L2
- R1A1: Raumwinkel, den Austrittswinkelbereich A1 dem Betrage nach nach oben hin begrenzend
- R1A2: Raumwinkel, den Austrittswinkelbereich A2 dem Betrage nach nach oben hin begrenzend
- R1A3: Raumwinkel, den Austrittswinkelbereich A3 dem Betrage nach nach oben hin begrenzend
- R2A1: Raumwinkel, den Austrittswinkelbereich A1 dem Betrage nach nach unten begrenzend
- R2A2: Raumwinkel, den Austrittswinkelbereich A2 dem Betrage nach nach unten begrenzend
- R2A3: Raumwinkel, den Austrittswinkelbereich A3 dem Betrage nach nach unten begrenzend
- T1: erster Teilabstrahlwinkel des Gesamtabstrahlwinkelbereichs der Leuchtdiode
- T2: zweiter Teilabstrahlwinkel des Gesamtabstrahlwinkelbereichs der Leuchtdiode

## Patentansprüche

1. Leuchtdiode (01) mit:
- mindestens einem LED-Chip (02),
- einer auf dem mindestens einen LED-Chip (02) aufstehenden Längsachse (03), sowie
- einem den LED-Chip (02) wenigstens zum Teil umhüllenden Lichtleitkörper (04), der mindestens zwei konzentrisch zu der Längsachse (03) und zueinander angeordnete Lichtaustrittsflächen (07, 08) aufweist,
**dadurch gekennzeichnet,**
**dass** das von dem LED-Chip (02) ausgestrahlte Licht (L1, L2) in unterschiedlichen Austrittswinkeln (A1, A2, A3) aus den verschiedenen Lichtaustrittsflächen (07, 08) aus dem Lichtleitkörper (04) austritt, wobei jeder Austrittswinkel (A1, A2, A3) aus den mindestens zwei Lichtaustrittsflächen (07, 08) einen Teilabstrahlwinkel (T1, T2) eines Gesamtabstrahlwinkels der Leuchtdiode (01) darstellt.

2. Leuchtdiode nach Anspruch 1,
**dadurch gekennzeichnet,**
**dass** der Gesamtabstrahlwinkel einen einzigen, zusammenhängenden Winkelbereich umfasst, oder mindestens zwei nicht zusammenhängende Winkelbereiche (T1, T2).

3. Leuchtdiode nach Anspruch 1 oder 2,
**dadurch gekennzeichnet,**
**dass** der Austrittswinkel jeder Lichtaustrittsfläche (07, 08) einen Austrittswinkelbereich (A1, A2, A3) umfasst.

4. Leuchtdiode nach Anspruch 1, 2 oder 3,
**dadurch gekennzeichnet,**
**dass** zumindest eine Lichtaustrittsfläche (07, 08) einen in seiner radialen Winkellage um die Längsachse (03) herum festgelegten Austrittswinkel (A3) aufweist, entsprechend einem in dieser radialen Winkellage schiefen Kegel.

5. Leuchtdiode nach einem der vorhergehenden Ansprüche,
**gekennzeichnet durch**
mindestens zwei Lichtaustrittsflächen (07, 08) mit jeweils einem Teilabstrahlwinkel (T1, T2), wobei die beiden Teilabstrahlwinkel (T1, T2) bei 0° und 20°, jeweils mit einer die beiden Austrittswinkelbereiche (A1, A2, A3) nach oben und unten begrenzenden Halbwertsbreite von 5°-7° liegen.

6. Leuchtdiode nach einem der vorhergehenden Ansprüche,
**dadurch gekennzeichnet,**
**dass** der Lichtleitkörper (04) angespritzt ist.

7. Leuchtdiode nach einem der vorhergehenden Ansprüche,
**dadurch gekennzeichnet,**
**dass** die Längsachse (03) mittig und/oder senkrecht auf der Oberfläche (06) des mindestens einen LED-Chips (02) aufsteht.

8. Leuchtdiode nach einem der vorhergehenden Ansprüche,
**dadurch gekennzeichnet,**
**dass** der Lichtleitkörper (04) eine geschlossene Mantelfläche (05) aufweist, welche von der Oberfläche (06) des LED-Chips (02) entlang der Längsachse (03) entfernt durch die konzentrischen Lichtaustrittsflächen (07, 08) abgeschlossen ist, wobei von dem LED-Chip (02) abgestrahltes Licht (L1, L2) zum Austritt aus dem Lichtleitkörper (04) entweder direkt auf eine erste Lichtaustrittsfläche (07) trifft, oder unter Totalreflexion zunächst an der Mantelfläche (05) im Lichtleitkörper (04) umgelenkt wird, bevor es dann auf eine zweite Lichtaustrittsfläche (08) trifft,

9. Leuchtdiode nach Anspruch 8,
**dadurch gekennzeichnet**
**dass** der Austritt aus dem Lichtleitkörper (04) durch eine erste Lichtaustrittsfläche (07) und/oder durch eine zweite Lichtaustrittsfläche (08) hindurch zumindest zum Teil unter Brechung beim Übergang vom Material des Lichtleitkörpers (04) zum diesen umgebenden Medium erfolgt.

10. Leuchtdiode nach einem der vorhergehenden Ansprüche,
**dadurch gekennzeichnet,**
**dass** entlang der Längsachse (03) eine erste, innere Lichtaustrittsfläche (07) von einer diese umgebenden, zweiten Lichtaustrittsfläche (08) in Richtung weg von der Oberfläche (06) des LED-Chips (02) überragt wird.
